# EUROPEAN PATENT SPECIFICATION

(11) **EP 2 834 856 B1**
(45) Date of publication and mention of the grant of the patent: **18.10.2017**
(21) Application number: 13772759.0
(22) Date of filing: 02.04.2013
(51) Int. Cl.: H01L 31/076, H01L 31/0376

(54) **THIN FILM SOLAR CELL**
DÜNNSCHICHTSOLARZELLE
CELLULE SOLAIRE EN COUCHE MINCE

(30) Priority: 03.04.2012 KR 20120034315
(43) Date of publication of application: 11.02.2015
(73) Proprietor: LG Electronics Inc., Seoul 150-721 (KR)
(72) Inventor: KIM, Soohyun, Seoul 137-724 (KR); LEE, Hongcheol, Seoul 137-724 (KR); CHUNG, Jinwon, Seoul 137-724 (KR); AHN, Sehwon, Seoul 137-724 (KR)
(74) Representative: Frenkel, Matthias Alexander
(86) International application number: PCT/KR2013/002707
(87) International publication number: WO 2013/151294

(56) References cited:
- EP-A1- 2 323 172
- JP-A- H0 595 126
- JP-A- H05 152 592
- JP-A- 2001 203 374
- JP-A- 2001 203 374
- JP-A- 2003 347 569
- JP-A- 2004 079 789
- JP-A- 2004 165 394
- JP-A- 2009 004 702
- JP-A- 2009 004 702
- JP-A- 2011 096 963
- US-A1- 2009 007 964
- US-A1- 2011 139 232

## Description

### Technical Field

Embodiments of the invention relate to a thin film solar cell.

### Background Art

Recently, as existing energy sources such as petroleum and coal are expected to be depleted, interests in alternative energy sources for replacing the existing energy sources are increasing. Among the alternative energy sources, solar cells for generating electric energy from solar energy have been particularly spotlighted.

A solar cell generally includes semiconductor parts, which respectively have different conductive types, for example, a p-type and an n-type and thus form a p-n junction, and electrodes respectively connected to the semiconductor parts of the different conductive types.

When light is incident on the solar cell, a plurality of electron-hole pairs are generated in the semiconductor parts. The electron-hole pairs are separated into electrons and holes by a photovoltaic effect. The electrons move to the n-type semiconductor part, and the holes move to the p-type semiconductor part. Then, the electrons and the holes are collected by the different electrodes respectively connected to the n-type semiconductor part and the p-type semiconductor part. The electrodes are connected to each other using electric wires to thereby obtain electric power. EP 2323 172 A1 describes a photoelectric conversion device from the prior art.

### Disclosure of Invention

### Solution to Problem

The subject matter of the present invention is defined in claim 1. Embodiments of the invention provide a thin film solar cell having the improved efficiency capable of reducing the manufacturing cost.

In one aspect, there is a thin film solar cell including a substrate, a first electrode and a second electrode positioned on one surface of the substrate, and a photoelectric conversion unit positioned between the first electrode and the second electrode, the photoelectric conversion unit including a plurality of photoelectric conversion layers each including a p-type semiconductor layer, an i-type semiconductor layer, and an n-type semiconductor layer, wherein at least one of the p-type semiconductor layers of the plurality of photoelectric conversion layers contains microcrystalline silicon (mc-Si) and amorphous silicon oxide (a-SiOx).

The photoelectric conversion unit includes a first photoelectric conversion layer contacting the first electrode and a second photoelectric conversion layer positioned between the first photoelectric conversion layer and the second electrode. A p-type semiconductor layer of the second photoelectric conversion layer may contain micro-crystalline silicon (mc-Si) and amorphous silicon oxide (a-SiOx).

Amorphous silicon oxide (a-SiOx) contained in the p-type semiconductor layer of the second photoelectric conversion layer may contain about 2 at% (atom%) to 10 at% of oxygen. Microcrystalline silicon (mc-Si) contained in the p-type semiconductor layer of the second photoelectric conversion layer may contain about 1 at% or less of oxygen or does not contain oxygen.

The p-type semiconductor layer of the second photoelectric conversion layer may directly contact an n-type semiconductor layer of the first photoelectric conversion layer. A thickness of the p-type semiconductor layer of the second photoelectric conversion layer may be greater than a thickness of an n-type semiconductor layer of the first photoelectric conversion layer.

More specifically, the thickness of the p-type semiconductor layer of the second photoelectric conversion layer may be about 50 nm and 100 nm.

The p-type semiconductor layer of the second photoelectric conversion layer may have crystallinity of about 5 % to 25 %.

The p-type semiconductor layer of the second photoelectric conversion layer may have a band gap of about 1.8 to 2.1 and a refractive index of about 1.8 to 2.6.

The p-type semiconductor layer of the second photoelectric conversion layer may include a first layer adjacent to the first photoelectric conversion layer and a second layer adjacent to an i-type semiconductor layer of the second photoelectric conversion layer. The first layer may contain microcrystalline silicon (mc-Si) and amorphous silicon (a-Si). The second layer may contain microcrystalline silicon (mc-Si) and amorphous silicon oxide (a-SiOx).

The first layer may contain about 2 at% or less of oxygen or may not contain oxygen. The second layer may contain about 2 at% to 10 at% of oxygen. A thickness of the first layer may be less than a thickness of the second layer. More specifically, the thickness of the first layer may be equal to or less than about 5 nm.

Each of a p-type semiconductor layer, an i-type semiconductor layer, and an n-type semiconductor layer included in the first photoelectric conversion layer may contain amorphous silicon (a-Si). Each of the p-type semiconductor layer, an i-type semiconductor layer, and an n-type semiconductor layer included in the second photoelectric conversion layer may contain microcrystalline silicon (mc-Si).

The photoelectric conversion unit may include a first photoelectric conversion layer contacting the first electrode, a second photoelectric conversion layer positioned between the first photoelectric conversion layer and the second electrode, and a third photoelectric conversion layer positioned between the second photoelectric conversion layer and the second electrode. At least one of p-type semiconductor layers of the second photoelectric conversion layer and the third photoelectric conversion layer may contain microcrystalline silicon (mc-Si) and amorphous silicon oxide (a-SiOx).

Amorphous silicon oxide (a-SiOx) in the at least one p-type semiconductor layer containing microcrystalline silicon (mc-Si) and amorphous silicon oxide (a-SiOx) may contain about 2 at% to 10 at% of oxygen, and microcrystalline silicon (mc-Si) may contain about 1 at% or less of oxygen or may not contain oxygen.

### Advantageous Effects of Invention

A thin film solar cell according to an example embodiment of the invention is configured so that at least one of p-type semiconductor layers included in other photoelectric conversion layers excluding a photoelectric conversion layer contacting a first electrode from a plurality of photoelectric conversion layers contains microcrystalline silicon (mc-Si) and amorphous silicon oxide (a-SiOx).

Accordingly, electrical characteristics of the at least one p-type semiconductor layer are secured due to microcrystalline silicon (mc-Si), and optical characteristics of the at least one p-type semiconductor layer are secured due to amorphous silicon oxide (a-SiOx).

### Brief Description of Drawings

The accompanying drawings, which are included to provide a further understanding of the invention and are incorporated in and constitute a part of this specification, illustrate embodiments of the invention and together with the description serve to explain the principles of the invention. In the drawings:
FIG. 1 illustrates a thin film solar cell according to an example embodiment of the invention;
FIG. 2 is an image photograph of a second p-type semiconductor layer taken with a transmission electron microscope (TEM);
FIG. 3 illustrates an example of an oxygen concentration in a second p-type semiconductor layer of a second photoelectric conversion layer;
FIG. 4 illustrates a relationship between a band gap and electrical conductivity;
FIG. 5 illustrates a relationship between a refractive index and electrical conductivity;
FIG. 6 illustrates another example of an oxygen concentration in a second p-type semiconductor layer of a second photoelectric conversion layer;
FIGS. 7 and 8 illustrate examples of securing high conductivity of a second p-type semiconductor layer of a second photoelectric conversion layer;
FIG. 9 illustrates an example where a solar cell according to an example embodiment of the invention includes a triple junction solar cell having a p-i-n/p-i-n/p-i-n structure; and
FIG. 10 illustrates an efficiency of a solar cell depending on a thickness of a p-type semiconductor layer containing microcrystalline silicon (mc-Si) and amorphous silicon oxide (a-SiOx).

### Mode for the Invention

Reference will now be made in detail to embodiments of the invention, examples of which are illustrated in the accompanying drawings. This invention may, however, be embodied in many different forms and should not be construed as limited to the embodiments set forth herein. Wherever possible, the same reference numbers will be used throughout the drawings to refer to the same or like parts. It will be paid attention that detailed description of known arts will be omitted if it is determined that the arts can mislead the embodiments of the invention.

In the drawings, the thickness of layers, films, panels, regions, etc., are exaggerated for clarity. It will be understood that when an element such as a layer, film, region, or substrate is referred to as being "on" another element, it can be directly on the other element or intervening elements may also be present. In contrast, when an element is referred to as being "directly on" another element, there are no intervening elements present. Further, it will be understood that when an element such as a layer, film, region, or substrate is referred to as being "entirely" on other element, it may be on the entire surface of the other element and may not be on a portion of an edge of the other element.

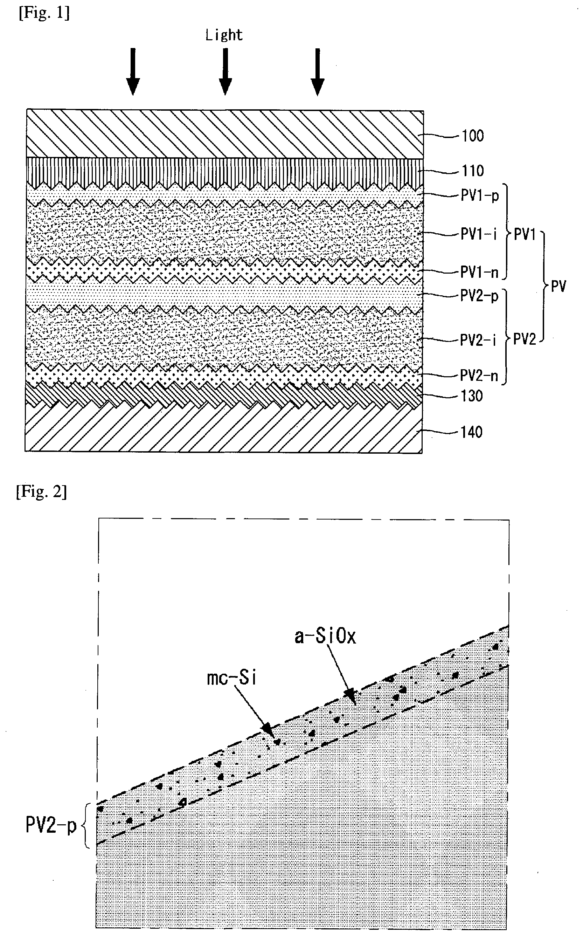

FIG. 1 illustrates a thin film solar cell according to an example embodiment of the invention.

As shown in FIG. 1, the thin film solar cell according to the embodiment of the invention includes a substrate 100, a first electrode 110, a photoelectric conversion unit PV, a back reflection layer 130, and a second electrode 140. The back reflection layer 130 may be omitted, if desired.

The substrate 100 may provide a space for other functional layers. The substrate 100 may be formed of a substantially transparent non-conductive material, for example, glass or plastic, so that light incident on the substrate 100 efficiently reaches the photoelectric conversion unit PV.

The first electrode 110 is positioned under the substrate 100 and contains a conductive material capable of transmitting light so as to increase a transmittance of incident light. For example, the first electrode 110 may contain transparent conductive oxide (TCO). Further, a specific resistance of the first electrode 110 may be about 10⁻² Ω · cm to 10⁻¹¹ Ω · cm.

The first electrode 110 may be electrically connected to the photoelectric conversion unit PV. Hence, the first electrode 110 may collect and output carriers (for example, holes) produced by incident light.

A plurality of uneven portions having a pyramid structure may be formed on a lower surface of the first electrode 110. In other words, the first electrode 110 may have a textured surface including the plurality of uneven portions. When the surface of the first electrode 110 is textured, the first electrode 110 may reduce a reflectance of incident light and increase an absorptance of the incident light. Hence, the efficiency of the thin film solar cell may be improved.

The second electrode 140 is separated from the lower surface of the first electrode 110 and is positioned under the photoelectric conversion unit PV. The second electrode 140 may be formed of a metal material with excellent electrical conductivity so as to increase a recovery efficiency of electric power generated by the photoelectric conversion unit PV. The second electrode 140 may be electrically connected to the photoelectric conversion unit PV and may collect and output carriers (for example, electrons) produced by incident light.

The second electrode 140 may contain at least one of silver (Ag) and aluminum (Al) with good electrical conductivity. The second electrode 140 may have a single-layered structure or a multi-layered structure.

So far, the embodiment of the invention described the structure of the solar cell in which light is incident from the substrate 100. However, in the embodiment of the invention, light may be incident from the second electrode 140 opposite the substrate 100. In this instance, the second electrode 140 is formed of a conductive material capable of transmitting light, and the first electrode 110 is formed of a metal material.

The back reflection layer 130 again reflects light, which is not absorbed in the photoelectric conversion unit PV, from the photoelectric conversion unit PV, thereby increasing an absorptance of the photoelectric conversion unit PV.

The photoelectric conversion unit PV is positioned between the first electrode 110 and the second electrode 140. The photoelectric conversion unit PV converts light incident on an incident surface of the substrate 100 from the outside into electricity.

The photoelectric conversion unit PV includes a first photoelectric conversion layer PV1 positioned on the first electrode 110 and a second photoelectric conversion layer PV2 positioned under the first photoelectric conversion layer PV1. Other layers may be included or present in the first and/or second photoelectric conversion layers or therebetween.

The first photoelectric conversion layer PV1 includes a p-type semiconductor layer PV1-p, an intrinsic (called i-type) semiconductor layer PV1-i, and an n-type semiconductor layer PV1-n. The second photoelectric conversion layer PV2 includes a p-type semiconductor layer PV2-p, an i-type semiconductor layer PV2-i, and an n-type semiconductor layer PV2-n.

FIG. 1 illustrates that the first and second photoelectric conversion layers PV1 and PV2 each have the p-i-n structure from the incident surface of the substrate 100. Alternatively, each of the first and second photoelectric conversion layers PV1 and PV2 may have an n-i-p structure from the incident surface of the substrate 100. In the following description, the embodiment of the invention describes that the first and second photoelectric conversion layers PV1 and PV2 each have the p-i-n structure from the incident surface of the substrate 100 as an example for the sake of brevity.

The p-type semiconductor layers PV1-p and PV2-p of the first and second photoelectric conversion layers PV1 and PV2 may be formed using a gas obtained by adding impurities of a first conductive type, for example, impurities of a group III element such as boron (B), gallium (Ga), and indium (In) to a raw gas containing silicon (Si). In the embodiment of the invention, when the p-type semiconductor layers PV1-p and PV2-p are doped with the impurities of the group III element, boron (B) causing a minimum defect may be used as an example.

The n-type semiconductor layers PV1-n and PV2-n may be formed using a gas obtained by adding impurities of a second conductive type opposite the first conductive type, for example, impurities of a group V element such as phosphorus (P), arsenic (As), and antimony (Sb) to a raw gas containing silicon (Si).

The i-type semiconductor layers PV1-i and PV2-i are respectively positioned between the p-type semiconductor layers PV1-p and PV2-p and the n-type semiconductor layers PV1-n and PV2-n. The i-type semiconductor layer PV1-i and PV2-i may prevent or reduce a recombination of carriers and may absorb light. The i-type semiconductor layer PV1-i and PV2-i may absorb incident light and may produce carriers such as electrons and holes.

The i-type semiconductor layer PV1-i may contain amorphous silicon, crystalline silicon, or microcrystalline silicon (mc-Si).

The photoelectric conversion unit of the double junction solar cell shown in FIG. 1 is described in detail below.

In the photoelectric conversion unit PV of the double junction solar cell according to the embodiment of the invention, a first p-type semiconductor layer PV1-p, a first i-type semiconductor layer PV1-i, a first n-type semiconductor layer PV1-n, a second p-type semiconductor layer PV2-p, a second i-type semiconductor layer PV2-i, and a second n-type semiconductor layer PV2-n may be sequentially stacked on the incident surface of the substrate 100 in the order named. Other layers may be included or present in the first and/or second photoelectric conversion layers or therebetween.

The first i-type semiconductor layer PV1-i may mainly absorb light of a short wavelength band to produce electrons and holes.

The second i-type semiconductor layer PV2-i may mainly absorb light of a long wavelength band to produce electrons and holes.

As described above, because the double junction solar cell absorbs light of the short wavelength band and light of the long wavelength band to produce carriers, the efficiency of the double junction solar cell may be improved.

In the double junction solar cell, the first p-type semiconductor layer PV1-p, the first i-type semiconductor layer PV1-i, and the first n-type semiconductor layer PV1-n of the first photoelectric conversion layer PV1 may contain amorphous silicon (a-Si), and the second i-type semiconductor layer PV2-i and the second n-type semiconductor layer PV2-n of the second photoelectric conversion layer PV2 contain micro-crystalline silicon (mc-Si).

The photoelectric conversion unit PV may be formed using a chemical vapor deposition (CVD) method such as a plasma enhanced CVD (PECVD) method.

As shown in FIG. 1, doped layers, for example, the p-type semiconductor layers PV1-p and PV2-p and the n-type semiconductor layers PV1-n and PV2-n of the first and second photoelectric conversion layers PV1 and PV2 may respectively form a p-n junction with the i-type semiconductor layer PV1-i and PV2-i interposed between the p-type and n-type semiconductor layers.

In such a structure of the thin film solar cell shown in FIG. 1, when light is incident on the p-type semiconductor layers PV1-p and PV2-p, a depletion region is formed inside the i-type semiconductor layers PV1-i and PV2-i because of the p-type semiconductor layers PV1-p and PV2-p and the n-type semiconductor layers PV1-n and PV2-n each having a relatively high doping concentration, thereby generating an electric field.

Electrons and holes, which are produced in a light absorbing layer, i.e., the i-type semiconductor layers PV1-i and PV2-i by a photovoltaic effect, are separated from each other by a contact potential difference and move in different directions.

For example, the holes may move to the first electrode 110 through the p-type semiconductor layers PV1-p and PV2-p, and the electrons may move to the second electrode 140 through the n-type semiconductor layers PV1-n and PV2-n. The electric power may be generated through the above-described method.

In the embodiment of the invention, the second p-type semiconductor layer PV2-p of the second photoelectric conversion layer PV2 contains microcrystalline silicon (mc-Si) and oxygen doped amorphous silicon oxide (a-SiOx) as shown in FIG. 2.

FIG. 2 is an image photograph of the second p-type semiconductor layer PV2-p taken with a transmission electron microscope (TEM).

In the second p-type semiconductor layer PV2-p shown in FIG. 2, a relatively dark portion is a precipitation portion of microcrystalline silicon (mc-Si), and a relatively bright portion is a formation portion of oxygen doped amorphous silicon oxide (a-SiOx).

The precipitation portion of microcrystalline silicon is a crystallization formation portion and thus has relatively large electrical conductivity. It is difficult to change a refractive index of the precipitation portion of microcrystalline silicon.

The formation portion of oxygen doped amorphous silicon oxide (a-SiOx) is a portion obtained by doping oxygen on amorphous silicon (a-Si). Thus, it is relatively easy to change a refractive index and electrical conductivity depending on an oxygen concentration.

Accordingly, the embodiment of the invention may adjust the electrical and optical characteristics of the second p-type semiconductor layer PV2-p by controlling the oxygen concentration of oxygen doped amorphous silicon oxide (a-SiOx). This is described in detail later.

As described above, because the second p-type semiconductor layer PV2-p contains microcrystalline silicon (mc-Si) and oxygen doped amorphous silicon oxide (a-SiOx), a band gap of the second p-type semiconductor layer PV2-p is improved and a refractive index of the second p-type semiconductor layer PV2-p is reduced.

The second p-type semiconductor layer PV2-p serves as the p-type semiconductor layer and also may serve as a middle reflection layer by increasing the reflectance of the second p-type semiconductor layer PV2-p.

More specifically, when the band gap of the second p-type semiconductor layer PV2-p is improved, an open-circuit voltage of the second photoelectric conversion layer PV2 may increase. An amount of light absorbed in the i-type semiconductor layer PV2-i of the second photoelectric conversion layer PV2 may increase due to an increase in the band gap of the second p-type semiconductor layer PV2-p.

Further, when the refractive index of the second p-type semiconductor layer PV2-p is reduced, a difference between refractive indexes of the first n-type semiconductor layers PV1-n and the second p-type semiconductor layer PV2-p increases. Hence, a reflectance of the first n-type semiconductor layers PV1-n may further increase.

The embodiment of the invention may increase the efficiency of the solar cell through an increase of the open-circuit voltage and may reduce the manufacturing cost because a separate middle reflection layer for reflecting light incident between the second p-type semiconductor layer PV2-p and the first n-type semiconductor layers PV1-n does not need to be formed.

As described above, because the second p-type semiconductor layer PV2-p contains microcrystalline silicon (mc-Si) and oxygen doped amorphous silicon oxide (a-SiOx), the open-circuit voltage of the second photoelectric conversion layer PV2 may increase without the separate middle reflection layer.

In the embodiment of the invention, the second p-type semiconductor layer PV2-p of the second photoelectric conversion layer PV2 may directly contact the first n-type semiconductor layer PV1-n of the first photoelectric conversion layer PV 1, and thus the manufacturing cost may be reduced without the separate middle reflection layer.

However, when the first n-type semiconductor layer PV1-n contains microcrystalline silicon (mc-Si) and oxygen doped amorphous silicon oxide (a-SiOx), it is difficult to increase an open-circuit voltage of the first photoelectric conversion layer PV1.

More specifically, when the first n-type semiconductor layer PV1-n contains micro-crystalline silicon (mc-Si) and oxygen doped amorphous silicon oxide (a-SiOx), a band gap of the first n-type semiconductor layer PV1-n may increase. However, an increase in the band gap of the first n-type semiconductor layer PV1-n does not affect the open-circuit voltage of the first photoelectric conversion layer PV1.

In the second p-type semiconductor layer PV2-p of the second photoelectric conversion layer PV2, oxygen doped amorphous silicon oxide (a-SiOx) contains about 2 at% (atom%) to 10 at% of oxygen, and microcrystalline silicon (mc-Si) may contain about 1 at% or less of oxygen or may not contain oxygen.

This is described in detail below.

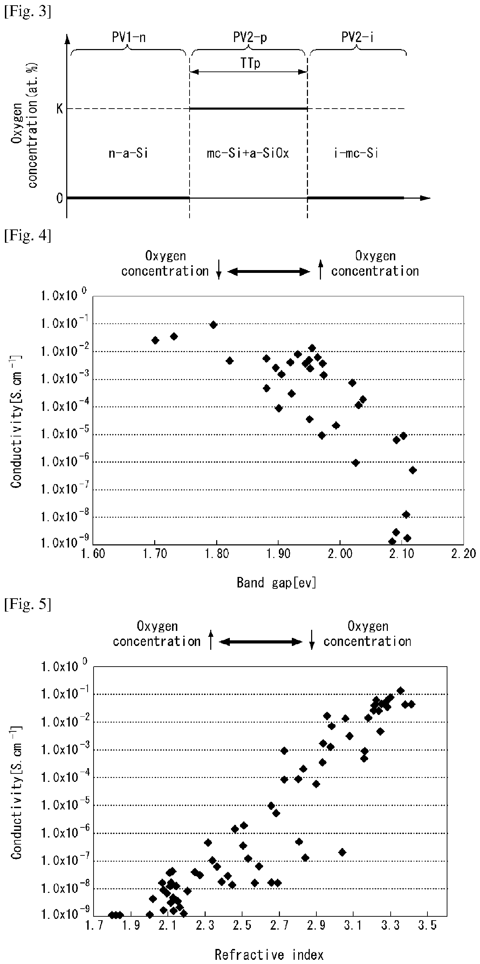

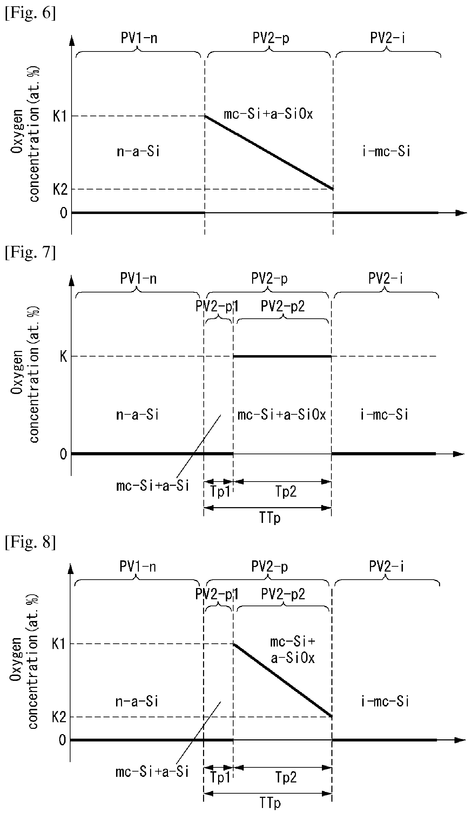

FIG. 3 illustrates an example of an oxygen concentration in the second p-type semiconductor layer PV2-p of the second photoelectric conversion layer PV2. FIG. 4 illustrates a relationship between a band gap and electrical conductivity. FIG. 5 illustrates a relationship between a refractive index and electrical conductivity. FIG. 6 illustrates another example of an oxygen concentration in the second p-type semiconductor layer PV2-p of the second photoelectric conversion layer PV2.

As shown in FIG. 3, the first n-type semiconductor layer PV1-n of the first photoelectric conversion layer PV1 and the second i-type semiconductor layer PV2-i of the second photoelectric conversion layer PV2 may not contain oxygen, and only the second p-type semiconductor layer PV2-p of the second photoelectric conversion layer PV2 may contain oxygen.

An oxygen concentration of the second p-type semiconductor layer PV2-p of the second photoelectric conversion layer PV2 may be determined as a predetermined concentration value "K" between 2 at% to 10 at%.

When the second p-type semiconductor layer PV2-p of the second photoelectric conversion layer PV2 contains oxygen, amorphous silicon oxide (a-SiOx) contained in the second p-type semiconductor layer PV2-p contains oxygen, and microcrystalline silicon (mc-Si) contained in the second p-type semiconductor layer PV2-p does not contain oxygen or contain about 1 at% or less of oxygen.

An oxygen concentration of amorphous silicon oxide (a-SiOx) may be determined as a previously determined value between 2 at% to 10 at%.

The oxygen concentration "K" of amorphous silicon oxide (a-SiOx) may be determined by adjusting a concentration ratio of a gas injected into a chamber in a process for depositing the second p-type semiconductor layer PV2-p.

For example, a process gas such as SiH₄, H₂ and B₂H₆ for layer deposition and a process gas such as CO₂ and O₂ for adjusting the oxygen concentration may be used to form the second p-type semiconductor layer PV2-p.

When the second p-type semiconductor layer PV2-p is deposited, the oxygen concentration K of amorphous silicon oxide (a-SiOx) contained in the second p-type semiconductor layer PV2-p may be adjusted by a concentration ratio 'b/a' of a concentration 'b' of the process gas such as CO2 and 02 to a concentration 'a' of SiH4 gas.

More specifically, when the concentration ratio 'b/a' increases, the oxygen concentration K of amorphous silicon oxide (a-SiOx) contained in the second p-type semiconductor layer PV2-p may increase. On the other hand, when the concentration ratio 'b/a' decreases, the oxygen concentration K of amorphous silicon oxide (a-SiOx) contained in the second p-type semiconductor layer PV2-p may decrease.

As described above, the electrical and optical characteristics of the second p-type semiconductor layer PV2-p may be adjusted by controlling the oxygen concentration K of amorphous silicon oxide (a-SiOx) of the second p-type semiconductor layer PV2-p.

In the embodiment of the invention, the electrical characteristics of the second p-type semiconductor layer PV2-p mean the electrical conductivity of the second p-type semiconductor layer PV2-p, and the optical characteristics of the second p-type semiconductor layer PV2-p mean the band gap and the refractive index of the second p-type semiconductor layer PV2-p.

The electrical conductivity of the second p-type semiconductor layer PV2-p serves as a main factor determining a short circuit current of the thin film solar cell. More specifically, when the electrical conductivity of the second p-type semiconductor layer PV2-p is equal to or greater than a predetermined level, the short circuit current of the thin film solar cell may further increase. On the contrary, when the electrical conductivity of the second p-type semiconductor layer PV2-p is less than the predetermined level, the short circuit current of the thin film solar cell may be reduced.

Further, the band gap of the second p-type semiconductor layer PV2-p serves as a main factor determining an open-circuit voltage of the thin film solar cell and also affects a light transmittance of the second p-type semiconductor layer PV2-p.

For example, when the band gap of the second p-type semiconductor layer PV2-p increases, the open-circuit voltage of the thin film solar cell increases. On the contrary, when the band gap of the second p-type semiconductor layer PV2-p decreases, the open-circuit voltage of the thin film solar cell decreases. Further, when the band gap of the second p-type semiconductor layer PV2-p increases, the light transmittance of the second p-type semiconductor layer PV2-p increases. Hence, an amount of light absorbed in the second i-type semiconductor layer PV2-i may increase, and the short circuit current of the thin film solar cell may increase.

On the contrary, when the band gap of the second p-type semiconductor layer PV2-p decreases, the light transmittance of the second p-type semiconductor layer PV2-p decreases. Hence, an amount of light absorbed in the second i-type semiconductor layer PV2-i may decrease, and the short circuit current of the thin film solar cell may decrease.

Further, the refractive index of the second p-type semiconductor layer PV2-p affects its reflectance. For example, when the refractive index of the second p-type semiconductor layer PV2-p increases, an amount of light reflected from the second p-type semiconductor layer PV2-p to the first photoelectric conversion layer PV1 decreases. On the contrary, when the refractive index of the second p-type semiconductor layer PV2-p decreases, an amount of light reflected from the second p-type semiconductor layer PV2-p to the first photoelectric conversion layer PV1 increases. Hence, a light absorptance of the first i-type semiconductor layer PV1-i may further increase, and the short circuit current of the thin film solar cell may be further improved.

Accordingly, the second p-type semiconductor layer PV2-p is required to have the electrical conductivity equal to or greater than the predetermined level, the high band gap, and the low refractive index, so as to improve the electrical and optical characteristics of the second p-type semiconductor layer PV2-p.

When the oxygen concentration K of amorphous silicon oxide (a-SiOx) contained in the second p-type semiconductor layer PV2-p increases, its band gap may increase. On the contrary, when the oxygen concentration K of amorphous silicon oxide (a-SiOx) contained in the second p-type semiconductor layer PV2-p decreases, its band gap may decrease.

Further, when the oxygen concentration K of amorphous silicon oxide (a-SiOx) contained in the second p-type semiconductor layer PV2-p increases, its refractive index may decrease. On the contrary, when the oxygen concentration K of amorphous silicon oxide (a-SiOx) contained in the second p-type semiconductor layer PV2-p decreases, its refractive index may increase.

However, when the refractive index is excessively reduced or the band gap excessively increases, the electrical conductivity may be reduced.

More specifically, as shown in FIG. 4, when the oxygen concentration K of the second p-type semiconductor layer PV2-p increases, the band gap increases. However, as the band gap increases, the electrical conductivity is reduced.

Further, as shown in FIG. 5, when the oxygen concentration K of the second p-type semiconductor layer PV2-p increases, the refractive index decreases. However, as the refractive index decreases, the electrical conductivity is reduced.

Accordingly, amorphous silicon oxide (a-SiOx) contained in the second p-type semiconductor layer PV2-p of the second photoelectric conversion layer PV2 may contain about 2 at% to 10 at% of oxygen in consideration of a relationship between the band gap and the electrical conductivity and a relationship between the refractive index and the electrical conductivity.

In other words, when the oxygen concentration K of the second p-type semiconductor layer PV2-p is equal to or greater than about 2 at%, the refractive index of the second p-type semiconductor layer PV2-p may be sufficiently reduced while its electrical conductivity equal to or greater than the predetermined level is secured. Hence, the reflectance of the second p-type semiconductor layer PV2-p may be sufficiently secured while its electrical conductivity equal to or greater than the predetermined level is secured.

Further, when the oxygen concentration K of the second p-type semiconductor layer PV2-p is equal to or less than about 10 at%, the band gap of the second p-type semiconductor layer PV2-p may sufficiently increase while its electrical conductivity equal to or greater than the predetermined level is secured. Hence, the transmittance of the second p-type semiconductor layer PV2-p may be sufficiently secured while its electrical conductivity equal to or greater than the predetermined level is secured.

Accordingly, the embodiment of the invention causes amorphous silicon oxide (a-SiOx) to contain about 2 at% to 10 at% of oxygen, thereby adjusting the band gap of the second p-type semiconductor layer PV2-p to about 1.8 to 2.1 eV and adjusting the refractive index of the second p-type semiconductor layer PV2-p to about 1.8 to 2.6.

Further, the second p-type semiconductor layer PV2-p according to the embodiment of the invention may adjust an amount of microcrystalline silicon (mc-Si) having the electrical conductivity better than amorphous silicon oxide (a-SiOx), so as to secure the electrical conductivity equal to or greater than the predetermined level.

For this, crystallinity of the second p-type semiconductor layer PV2-p of the second photoelectric conversion layer PV2 may be about 5 % to 25 %.

In the embodiment of the invention, the crystallinity of the second p-type semiconductor layer PV2-p indicates a volume percentage which microcrystalline silicon (mc-Si) occupies in the total volume of the second p-type semiconductor layer PV2-p.

The crystallinity of the second p-type semiconductor layer PV2-p may be adjusted by a concentration ratio 'c/a' of a concentration 'c' of H2 gas to a concentration 'a' of SiH 4 gas.

More specifically, when the concentration ratio 'c/a' increases, the crystallinity of the second p-type semiconductor layer PV2-p may increase. On the contrary, when the concentration ratio 'c/a' decreases, the crystallinity of the second p-type semiconductor layer PV2-p may decrease.

However, the electrical conductivity of the second p-type semiconductor layer PV2-p excessively increases, the short circuit current may increase, but there is a limit to an increase in the optical characteristics (i.e., the band gap and the refractive index) of the second p-type semiconductor layer PV2-p.

Accordingly, it is important to properly secure the electrical conductivity of the second p-type semiconductor layer PV2-p to the extent that the short circuit current is not reduced.

Considering this, the embodiment of the invention may adjust the crystallinity of the second p-type semiconductor layer PV2-p to about 5 % to 25 %.

Further, a thickness TTp of the second p-type semiconductor layer PV2-p of the second photoelectric conversion layer PV2 may be greater than a thickness of the first n-type semiconductor layer PV1-n of the first photoelectric conversion layer PV1.

This is to sufficiently secure the reflectance resulting from the second p-type semiconductor layer PV2-p by sufficiently securing the thickness TTp of the second p-type semiconductor layer PV2-p.

However, when the thickness TTp of the second p-type semiconductor layer PV2-p is excessively thick, the reflectance resulting from the second p-type semiconductor layer PV2-p excessively increases. Hence, an amount of light absorbed in the first i-type semiconductor layer PV1-i may increase, but an amount of light absorbed in the second i-type semiconductor layer PV2-i may excessively decrease. As a result, the short circuit current of the thin film solar cell may entirely decrease. Thus, the thickness TTp of the second p-type semiconductor layer PV2-p has to be optimized.

Accordingly, the thickness TTp of the second p-type semiconductor layer PV2-p of the second photoelectric conversion layer PV2 may be determined between about 50 nm and 100 nm.

When the thickness TTp of the second p-type semiconductor layer PV2-p is determined between about 50 nm and 100 nm, the electrical conductivity, the band gap, and the refractive index of the second p-type semiconductor layer PV2-p may be sufficiently secured.

As described above, when the second p-type semiconductor layer PV2-p has the optimum thickness TTp, the electrical conductivity, the band gap, and the refractive index of the second p-type semiconductor layer PV2-p may be sufficiently secured. Hence, optimum conditions of the short circuit current capable of maximizing the efficiency of the first and second photoelectric conversion layers PV1 and PV2 may be obtained.

More specifically, when the thickness TTp of the second p-type semiconductor layer PV2-p is less than about 50 nm, an amount of light reflected from the second p-type semiconductor layer PV2-p relatively decreases, and an amount of light transmitted by the second p-type semiconductor layer PV2-p relatively increases. Hence, the short circuit current of the second photoelectric conversion layer PV2 may entirely increase. However, the short circuit current of the first photoelectric conversion layer PV1 may decrease.

Further, when the thickness TTp of the second p-type semiconductor layer PV2-p is greater than about 100 nm, an amount of light reflected from the second p-type semiconductor layer PV2-p relatively increases, and an amount of light transmitted by the second p-type semiconductor layer PV2-p relatively decreases. Hence, the short circuit current of the first photoelectric conversion layer PV1 may entirely increase. However, the short circuit current of the second photoelectric conversion layer PV2 may decrease.

Accordingly, the thickness TTp of the second p-type semiconductor layer PV2-p may be determined between about 50 nm and 100 nm, so that a loss current is minimized though a minimum difference between the short circuit currents of the first and second photoelectric conversion layers PV1 and PV2 in consideration of the short circuit currents of the first and second photoelectric conversion layers PV1 and PV2.

As a result, all of the reflectance, the transmittance, and the electrical conductivity of the second p-type semiconductor layer PV2-p according to the embodiment of the invention may be improved.

More specifically, as shown in FIG. 3, because the reflectance is determined by an amount of light reflected from an interface of the second p-type semiconductor layer PV2-p directly contacting the first n-type semiconductor layer PV1-n, the reflectance serves as an important factor at the interface.

Further, because the transmittance related to the band gap is determined by an amount of light entirely absorbed in the second p-type semiconductor layer PV2-p, the transmittance is determined by the concentration K of oxygen entirely contained in the second p-type semiconductor layer PV2-p.

Electrons and holes are generated in the second i-type semiconductor layer PV2-i through light absorbed in the second i-type semiconductor layer PV2-i, and the holes move to the second p-type semiconductor layer PV2-p. Therefore, the electrical conductivity serves as an important factor at an interface of the second p-type semiconductor layer PV2-p directly contacting the second i-type semiconductor layer PV2-i.

Accordingly, as shown in FG. 6, an oxygen concentration K1 at the interface of the second p-type semiconductor layer PV2-p directly contacting the first n-type semiconductor layer PV1-n may be higher than an oxygen concentration K2 at the interface of the second p-type semiconductor layer PV2-p directly contacting the second i-type semiconductor layer PV2-i.

Hence, a refractive index at the interface of the second p-type semiconductor layer PV2-p directly contacting the first n-type semiconductor layer PV1-n may be further reduced, and a reflectance at the interface of the second p-type semiconductor layer PV2-p directly contacting the first n-type semiconductor layer PV1-n may be further improved.

Further, the electrical conductivity at the interface of the second p-type semiconductor layer PV2-p directly contacting the second i-type semiconductor layer PV2-i may be further improved, and a concentration of oxygen entirely contained in the second i-type semiconductor layer PV2-i may be sufficiently secured. Hence, the transmittance and the band gap of the second p-type semiconductor layer PV2-p may be further improved.

As a result, the short circuit current and the open-circuit voltage of the thin film solar cell may be further improved.

FIGS. 7 and 8 illustrate examples of securing the high conductivity of the second p-type semiconductor layer of the second photoelectric conversion layer.

As described above, the oxygen concentration K at the interface of the second p-type semiconductor layer PV2-p directly contacting the first n-type semiconductor layer PV1-n has to increase so as to properly secure the reflectance.

However, when the electrical conductivity is excessively reduced due to an excessive increase in the oxygen concentration K at the interface of the second p-type semiconductor layer PV2-p directly contacting the first n-type semiconductor layer PV1-n, a resistance of the second p-type semiconductor layer PV2-p, which forms a tunneling junction along with the first n-type semiconductor layer PV1-n, may increase at the interface of the second p-type semiconductor layer PV2-p directly contacting the first n-type semiconductor layer PV1-n. Hence, a fill factor of the thin film solar cell may be reduced.

As shown in FIG. 7, a layer for securing the high conductivity may be added to the interface of the second p-type semiconductor layer PV2-p directly contacting the first n-type semiconductor layer PV1-n, so as to prevent a reduction in the fill factor of the thin film solar cell. Hence, the second p-type semiconductor layer PV2-p of the second photoelectric conversion layer PV2 may be divided into two layers.

More specifically, the second p-type semiconductor layer PV2-p may include a first layer PV2-P1 positioned at the interface of the second p-type semiconductor layer PV2-p directly contacting the first n-type semiconductor layer PV1-n and a second layer PV2-P2 positioned at the interface of the second p-type semiconductor layer PV2-p directly contacting the second i-type semiconductor layer PV2-i.

The first layer PV2-P1 adjacent to the first photoelectric conversion layer PV1 forms a tunneling junction along with the first n-type semiconductor layer PV1-n and thus may contain both microcrystalline silicon (mc-Si) and amorphous silicon (a-Si) so as to secure the high conductivity. The second layer PV2-P2 adjacent to the second i-type semiconductor layer PV2-i may contain both microcrystalline silicon (mc-Si) and amorphous silicon oxide (a-SiOx) so as to secure the high conductivity.

The first layer PV2-P1 forming the tunneling junction along with the first n-type semiconductor layer PV1-n may contain about 2 at% or less of oxygen or may not contain oxygen, so as to secure the high conductivity. The second layer PV2-P2 may contains about 2 at% to 10 at% of oxygen as described above with reference to FIG. 3.

The first layer PV2-P1 is a layer to form the tunneling junction along with the first n-type semiconductor layer PV1-n, and thus a thickness Tp1 of the first layer PV2-P1 does not need to be thick.

Accordingly, the thickness Tp1 of the first layer PV2-P1 may be less than a thickness Tp2 of the second layer PV2-P2. For example, the thickness Tp1 of the first layer PV2-P1 may be equal to or less than about 5 nm.

As shown in FIG. 8, an oxygen concentration K1 at an interface between the first layer PV2-P1 and the second layer PV2-P2 may be higher than the oxygen concentration K2 at the interface of the second p-type semiconductor layer PV2-p directly contacting the second i-type semiconductor layer PV2-i.

Hence, the efficiency of the thin film solar cell may be further improved.

So far, the embodiment of the invention described that when the first photoelectric conversion layer PV1 contains amorphous silicon (a-Si) and the second i-type semiconductor layer PV2-i contains microcrystalline silicon (mc-Si), the open-circuit voltage and the short circuit current of the double junction solar cell are adjusted by adjusting the oxygen concentration of the second p-type semiconductor layer PV2-p. However, the second p-type semiconductor layer PV2-p of the second photoelectric conversion layer PV2 according to the embodiment of the invention may be equally applied even when the first photoelectric conversion layer PV1 contains micro-crystalline silicon (mc-Si).

Further, the p-type semiconductor layer according to the embodiment of the invention containing microcrystalline silicon (mc-Si) and amorphous silicon oxide (a-SiOx) may be equally applied to a triple junction solar cell.

An example of applying the p-type semiconductor layer containing microcrystalline silicon (mc-Si) and amorphous silicon oxide (a-SiOx) to the triple junction solar cell is described below.

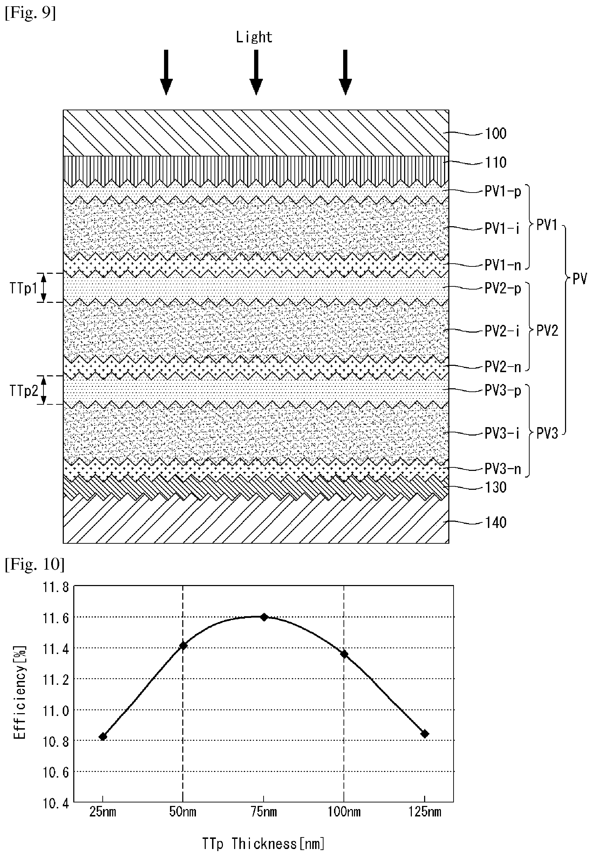

FIG. 9 illustrates an example where the solar cell according to the embodiment of the invention includes a triple junction solar cell having a p-i-n/p-i-n/p-i-n structure. FIG. 10 illustrates the efficiency of the solar cell depending on a thickness of a p-type semiconductor layer containing microcrystalline silicon (mc-Si) and amorphous silicon oxide (a-SiOx).

Structures and components identical or equivalent to those described above may be briefly made or may be entirely omitted below.

As shown in FIG. 9, a photoelectric conversion unit PV of the triple junction solar cell may include a first photoelectric conversion layer PV1, a second photoelectric conversion layer PV2, and a third photoelectric conversion layer PV3 that are sequentially positioned on the incident surface of the substrate 100 in the order named. Other layers may be included or present in the first, second and/or third photoelectric conversion layers or therebetween.

More specifically, the first photoelectric conversion layer PV1 contacts the first electrode 110, and the second photoelectric conversion layer PV2 is positioned on the first photoelectric conversion layer PV1 and contacts the first photoelectric conversion layer PV1. Further, the third photoelectric conversion layer PV3 is positioned on the second photoelectric conversion layer PV2 and contacts the second photoelectric conversion layer PV2.

In the embodiment of the invention, each of the first photoelectric conversion layer PV1, the second photoelectric conversion layer PV2, and the third photoelectric conversion layer PV3 may have the p-i-n structure. Thus, a first p-type semiconductor layer PV1-p, a first i-type semiconductor layer PV1-i, a first n-type semiconductor layer PV1-n, a second p-type semiconductor layer PV2-p, a second i-type semiconductor layer PV2-i, a second n-type semiconductor layer PV2-n, a third p-type semiconductor layer PV3-p, a third i-type semiconductor layer PV3-i, and a third n-type semiconductor layer PV3-p may be sequentially positioned on the substrate 100 in the order named. Other layers may be included or present in the first, second, and/or third photoelectric conversion layers or therebetween.

The first photoelectric conversion layer PV1 may absorb light of a short wavelength band to produce electric power, and the second photoelectric conversion layer PV2 may absorb light of a middle wavelength band between a short wavelength band and a long wavelength band to produce electric power. Further, the third photoelectric conversion layer PV3 may absorb light of a long wavelength band to produce electric power.

The first i-type semiconductor layer PV1-i, the second i-type semiconductor layer PV2-i, and the third i-type semiconductor layer PV3-i may be variously implemented.

As a first example of the configuration illustrated in FIG. 9, the first i-type semiconductor layer PV1-i and the second i-type semiconductor layer PV2-i may contain amorphous silicon (a-Si), and the third i-type semiconductor layer PV3-i may contain microcrystalline silicon (mc-Si).

As a second example of the configuration illustrated in FIG. 9, the first i-type semiconductor layer PV1-i may contain amorphous silicon (a-Si), and the second i-type semiconductor layer PV2-i and the third i-type semiconductor layer PV3-i may contain microcrystalline silicon (mc-Si).

The triple junction solar cell according to the embodiment of the invention may include a p-type semiconductor layer containing microcrystalline silicon (mc-Si) and amorphous silicon oxide (a-SiOx) in the same manner as the double junction solar cell.

In other words, at least one of p-type semiconductor layers included in the second photoelectric conversion layer PV2 and the third photoelectric conversion layer PV3 may contain both microcrystalline silicon (mc-Si) and amorphous silicon oxide (a-SiOx).

More specifically, only the second p-type semiconductor layer PV2-p may contain microcrystalline silicon (mc-Si) and amorphous silicon oxide (a-SiOx), or only the third p-type semiconductor layer PV3-p may contain microcrystalline silicon (mc-Si) and amorphous silicon oxide (a-SiOx). Alternatively, each of the second p-type semiconductor layer PV2-p and the third p-type semiconductor layer PV3-p may contain microcrystalline silicon (mc-Si) and amorphous silicon oxide (a-SiOx).

As described above, the triple junction solar cell according to the embodiment of the invention includes the p-type semiconductor layer containing microcrystalline silicon (mc-Si) and amorphous silicon oxide (a-SiOx), and thus an open-circuit voltage and a short circuit current of the triple junction solar cell may be improved.

When at least one of the second p-type semiconductor layer PV2-p and the third p-type semiconductor layer PV3-p contains microcrystalline silicon (mc-Si) and amorphous silicon oxide (a-SiOx), amorphous silicon oxide (a-SiOx) of the at least one p-type semiconductor layer may contain about 2 at% to 10 at% of oxygen, and micro-crystalline silicon (mc-Si) may contain about 1 at% or less of oxygen or may not contain oxygen.

When at least one of the second p-type semiconductor layer PV2-p and the third p-type semiconductor layer PV3-p contains microcrystalline silicon (mc-Si) and amorphous silicon oxide (a-SiOx), an oxygen concentration of the at least one p-type semiconductor layer may equally use the description of FIGS. 3 to 6.

In the triple junction solar cell according to the embodiment of the invention, at least one of the p-type semiconductor layers included in the second photoelectric conversion layer PV2 and the third photoelectric conversion layer PV3 may include a first layer PV2-P1 containing microcrystalline silicon (mc-Si) and amorphous silicon oxide (a-SiOx) and a second layer PV2-P2 containing microcrystalline silicon (mc-Si) and amorphous silicon oxide (a-SiOx), in the same manner as the double junction solar cell.

Hence, the electrical conductivity of at least one of the p-type semiconductor layers included in the second and third photoelectric conversion layers PV2 and PV3 may be further improved.

An oxygen concentration of the second layer PV2-P2 may equally use the description of FIGS. 7 and 8.

The p-type semiconductor layer containing microcrystalline silicon (mc-Si) and amorphous silicon oxide (a-SiOx) serves as a middle reflection layer as well as the function of the p-type semiconductor layer as described in FIGS. 1 to 8. Therefore, a thickness of the p-type semiconductor layer containing microcrystalline silicon (mc-Si) and amorphous silicon oxide (a-SiOx) may be greater than a thickness of the n-type semiconductor layer contacting the p-type semiconductor layer.

For example, in FIG. 9, when each of the second p-type semiconductor layer PV2-p and the third p-type semiconductor layer PV3-p contains microcrystalline silicon (mc-Si) and amorphous silicon oxide (a-SiOx), thicknesses TTp1 and TTp2 of the second p-type semiconductor layer PV2-p and the third p-type semiconductor layer PV3-p may be greater than thicknesses of the first n-type semiconductor layer PV1-n and the second n-type semiconductor layer PV2-n. For example, the thicknesses TTp1 and TTp2 of the second p-type semiconductor layer PV2-p and the third p-type semiconductor layer PV3-p may be about 50 nm to 100 nm.

A light absorptance of each of the first i-type semiconductor layer PV1-i, the second i-type semiconductor layer PV2-i, and the third i-type semiconductor layer PV3-i varies depending on the thicknesses TTp1 and TTp2 of the second p-type semiconductor layer PV2-p and the third p-type semiconductor layer PV3-p. Therefore, as shown in FIG. 10, when the thicknesses TTp1 and TTp2 of the second p-type semiconductor layer PV2-p and the third p-type semiconductor layer PV3-p are about 50 nm to 100 nm in consideration of the light absorptance of the i-type semiconductor layers, the efficiency of the thin film solar cell is maximized.

As described above, the thin film solar cell according to the embodiment of the invention causes the p-type semiconductor layer containing microcrystalline silicon (mc-Si) and amorphous silicon oxide (a-SiOx) to serve as the middle reflection layer as well as the function of the p-type semiconductor layer, and thus does not include a separate middle reflection layer between the plurality of photoelectric conversion layers. Hence, the manufacturing cost of the thin film solar cell may be reduced.

Although embodiments have been described with reference to a number of illustrative embodiments thereof, it should be understood that numerous other modifications and embodiments can be devised by those skilled in the art that will fall within the scope of the principles of this disclosure. More particularly, various variations and modifications are possible in the component parts and/or arrangements of the subject combination arrangement within the scope of the disclosure, the drawings and the appended claims. In addition to variations and modifications in the component parts and/or arrangements, alternative uses will also be apparent to those skilled in the art.

## Claims

1. A thin film solar cell comprising:
a substrate (100);
a first electrode (110) positioned on one surface of the substrate; and
a photoelectric conversion unit (PV) including a first photoelectric conversion layer (PV1) contacting the first electrode (110) and a second photoelectric conversion layer (PV2) positioned between the first photoelectric conversion layer (PV1) and a second electrode (140), each photoelectric conversion layer including a p-type semiconductor layer (PV1-p, PV2-p) doped with impurities of a first conductive type, an i-type semiconductor layer (PV1-i, PV2-i), and an n-type semiconductor layer (PV1-n, PV2-n) doped with impurities of a second conductive type opposite the first conductive type,
**characterized in that**
the n-type semiconductor layer (PV1-n) of the first photoelectric conversion layer (PV-1) contains amorphous silicon (a-Si),
the p-type semiconductor layer (PV2-p) of the second photoelectric conversion layer (PV2) contains microcrystalline silicon (mc-Si) and amorphous silicon oxide (a-SiOx), and
the i-type semiconductor layer (PV2-i) and the n-type semiconductor layer (PV2-n) of the second photoelectric conversion layer (PV2) contain micro-crystalline silicon (mc-Si).

2. The thin film solar cell of claim 1, wherein amorphous silicon oxide (a-SiOx) contained in the p-type semiconductor layer (PV2-p) of the second photoelectric conversion layer (PV2) contains 2 at% (atom%) to 10 at% of oxygen,
wherein microcrystalline silicon (mc-Si) contained in the p-type semiconductor layer (PV2-p) of the second photoelectric conversion layer (PV2) contains 1 at% or less of oxygen or does not contain oxygen.

3. The thin film solar cell of claim 1, wherein the p-type semiconductor layer (PV2-p) of the second photoelectric conversion layer (PV2) directly contacts the n-type semiconductor layer (PV1-n) of the first photoelectric conversion layer (PV1).

4. The thin film solar cell of claim 1, wherein a thickness of the p-type semiconductor layer (PV2-p) of the second photoelectric conversion layer (PV2) is greater than a thickness of the n-type semiconductor layer (PV1-n) of the first photoelectric conversion layer (PV1).

5. The thin film solar cell of claim 4, wherein the thickness of the p-type semiconductor layer (PV2-p) of the second photoelectric conversion layer (PV2) is 50 nm to 100 nm.

6. The thin film solar cell of claim 1, wherein the p-type semiconductor layer (PV2-p) of the second photoelectric conversion layer (PV2) has crystallinity of 5 % to 25%.

7. The thin film solar cell of claim 1, wherein the p-type semiconductor layer (PV2-p) of the second photoelectric conversion layer (PV2) has a band gap of 1.8 to 2.1.

8. The thin film solar cell of claim 1, wherein the p-type semiconductor layer (PV2-p) of the second photoelectric conversion layer (PV2) has a refractive index of 1.8 to 2.6.

9. The thin film solar cell of claim 1, wherein the p-type semiconductor layer (PV2-p) of the second photoelectric conversion layer (PV2) includes a first layer (PV2-P1) adjacent to the first photoelectric conversion layer (PV1) and a second layer (PV2-P2) adjacent to the i-type semiconductor layer (PV2-i) of the second photoelectric conversion layer (PV2),
wherein the first layer contains microcrystalline silicon (mc-Si) and amorphous silicon (a-Si), and
wherein the second layer contains microcrystalline silicon (mc-Si) and amorphous silicon oxide (a-Si:Ox).

10. The thin film solar cell of claim 9, wherein the first layer (PV2-P1) contains 2 at% or less of oxygen or does not contain oxygen,
wherein the second layer (PV2-P2) contains 2 at% to 10 at% of oxygen.

11. The thin film solar cell of claim 9, wherein a thickness of the first layer (PV2-P1) is less than a thickness of the second layer (PV2-P2).

12. The thin film solar cell of claim 9, wherein a thickness of the first layer (PV2-P1) is equal to or less than about 5 nm.

13. The thin film solar cell of claim 1, wherein each of the p-type semiconductor layer (PV1-p), the i-type semiconductor layer (PV1-i), and the n-type semiconductor layer (PV1-n) included in the first photoelectric conversion layer (PV1) contains amorphous silicon (a-Si),
wherein each of the p-type semiconductor layer (PV2-p), the i-type semiconductor layer (PV2-i), and the n-type semiconductor layer (PV2-n) included in the second photoelectric conversion layer (PV2) contains microcrystalline silicon (mc-Si).

14. The thin film solar cell of claim 1, wherein the photoelectric conversion unit (PV) includes the first photoelectric conversion layer (PV1) contacting the first electrode (110), the second photoelectric conversion layer (PV2) positioned between the first photoelectric conversion layer (PV1) and the second electrode (140), and a third photoelectric conversion layer (PV3) positioned between the second photoelectric conversion layer (PV2) and the second electrode (140),
wherein the p-type semiconductor layers (PV2-p, PV3-p) of the second photoelectric conversion layer (PV2) and the third photoelectric conversion layer (PV3) contain microcrystalline silicon (mc-Si) and amorphous silicon oxide (a-SiOx).

15. The thin film solar cell of claim 14, wherein the amorphous silicon oxide (a-SiOx) in the p-type semiconductor layers (PV2-p, PV3-p) containing microcrystalline silicon (mc-Si) and amorphous silicon oxide (a-SiOx) contains 2 at% to 10 at% of oxygen, and the microcrystalline silicon (mc-Si) contains 1 at% or less of oxygen or does not contain oxygen.

## Patentansprüche

1. Dünnschichtsolarzelle umfassend:
ein Substrat (100);
eine erste Elektrode (110), die auf einer Oberfläche des Substrats angeordnet ist; und
eine photoelektrische Umwandlungseinheit (PV), welche eine die erste Elektrode (110) kontaktierende erste photoelektrische Umwandlungsschicht (PV1) und eine zwischen der ersten photoelektrischen Umwandlungsschicht (PV1) und einer zweiten Elektrode (140) angeordnete zweite photoelektrische Umwandlungsschicht (PV2) umfasst, wobei jede der photoelektrischen Umwandlungsschichten eine mit Störstoffen eines ersten Leitfähigkeitstyps dotierte p-Typ Halbleiterschicht (PV1-p, PV2-p), eine i-Typ Halbleiterschicht (PV1-i, PV2-i) und eine mit Störstoffen eines zu dem ersten Leitfähigkeitstyp entgegengesetzten zweiten Leitfähigkeitstyps dotierten n-Typ Halbleiterschicht (PV1-n, PV2-n) umfasst,
**dadurch gekennzeichnet dass**
die n-Typ Halbleiterschicht (PV1-n) der ersten photoelektrischen Umwandlungsschicht (PV1) amorphes Silizium (a-Si) enthält,
die p-Typ Halbleiterschicht (PV2-p) der zweiten photoelektrischen Umwandlungsschicht (PV2) mikrokristallines Silizium (mc-Si) und amorphes Siliziumoxid (a-SiOx) enthält, und
die i-Typ Halbleiterschicht (PV2-i) und die n-Typ Halbleiterschicht (PV2-n) der zweiten photoelektrischen Umwandlungsschicht (PV2) mikrokristallines Silizium (mc-Si) enthält.

2. Dünnschichtsolarzelle nach Anspruch 1, wobei amorphes Siliziumoxid (a-SiOx), das in der p-Typ Halbleiterschicht (PV2-p) der zweiten photoelektrischen Umwandlungsschicht (PV2) enthalten ist, 2 at% (Atom%) bis 10 at% (Atom%) Sauerstoff enthält,
wobei mikrokristallines Silizium (mc-Si), das in der p-Typ Halbleiterschicht (PV2-p) der zweiten photoelektrischen Umwandlungsschicht (PV2) enthalten ist, 1 at% oder weniger Sauerstoff enthält oder keinen Sauerstoff enthält.

3. Dünnschichtsolarzelle nach Anspruch 1, wobei die p-Typ Halbleiterschicht (PV2-p) der zweiten photoelektrischen Umwandlungsschicht (PV2) direkt die n-Typ Halbleiterschicht (PV1-n) der ersten photoelektrischen Umwandlungsschicht (PV1) kontaktiert.

4. Dünnschichtsolarzelle nach Anspruch 1, wobei eine Dicke der p-Typ Halbleiterschicht (PV2-p) der zweiten photoelektrischen Umwandlungsschicht (PV2) größer als eine Dicke der n-Typ Halbleiterschicht (PV1-n) der ersten photoelektrischen Umwandlungsschicht (PV1) ist.

5. Dünnschichtsolarzelle nach Anspruch 4, wobei die Dicke der p-Typ Halbleiterschicht (PV2-p) der zweiten photoelektrischen Umwandlungsschicht (PV2) 50 nm bis 100 nm beträgt.

6. Dünnschichtsolarzelle nach Anspruch 1, wobei die p-Typ Halbleiterschicht (PV2-p) der zweiten photoelektrischen Umwandlungsschicht (PV2) eine Kristallinität von 5% bis 25% aufweist.

7. Dünnschichtsolarzelle nach Anspruch 1, wobei die p-Typ Halbleiterschicht (PV2-p) der zweiten photoelektrischen Umwandlungsschicht (PV2) eine Bandlücke von 1,8 bis 2,1 aufweist.

8. Dünnschichtsolarzelle nach Anspruch 1, wobei die p-Typ Halbleiterschicht (PV2-p) der zweiten photoelektrischen Umwandlungsschicht (PV2) einen Brechungsindex von 1,8 bis 2,6 aufweist.

9. Dünnschichtsolarzelle nach Anspruch 1, wobei die p-Typ Halbleiterschicht (PV2-p) der zweiten photoelektrischen Umwandlungsschicht (PV2) eine zu der ersten photoelektrischen Umwandlungsschicht (PV1) benachbarte erste Schicht (PV2-P1) und eine zu der i-Typ Halbleiterschicht (PV2-i) der zweiten photoelektrischen Umwandlungsschicht (PV2) benachbarte zweite Schicht (PV2-P2) umfasst,
wobei die erste Schicht mikrokristallines Silizium (mc-Si) und amorphes Silizium (a-Si) enthält, und
wobei die zweite Schicht mikrokristallines Silizium (mc-Si) und amorphes Siliziumoxid (a-Si:Ox) enthält.

10. Dünnschichtsolarzelle nach Anspruch 9, wobei die erste Schicht (PV2-P1) 2 at% oder weniger Sauerstoff enthält oder keinen Sauerstoff enthält,
wobei die zweite Schicht (PV2-P2) 2 at% bis 10 at% Sauerstoff enthält.

11. Dünnschichtsolarzelle nach Anspruch 9, wobei eine Dicke der ersten Schicht (PV2-P1) weniger als eine Dicke der zweiten Schicht (PV2-P2) ist.

12. Dünnschichtsolarzelle nach Anspruch 9, wobei eine Dicke der ersten Schicht (PV2-P1) gleich zu oder weniger als etwa 5 nm ist.

13. Dünnschichtsolarzelle nach Anspruch 1, wobei sowohl die p-Typ Halbleiterschicht (PV1-p), als auch die i-Typ Halbleiterschicht (PV1-i) und die n-Typ Halbleiterschicht (PV1-n), die in der ersten photoelektrischen Umwandlungsschicht (PV1) umfasst sind, amorphes Silizium (a-Si) enthalten,
wobei sowohl die p-Typ Halbleiterschicht (PV2-p), als auch die i-Typ Halbleiterschicht (PV2-1) und die n-Typ Halbleiterschicht (PV2-n), die in der zweiten photoelektrischen Umwandlungsschicht (PV2) enthalten sind, mikrokristallines Silizium (mc-Si) enthalten.

14. Dünnschichtsolarzelle nach Anspruch 1, wobei die photoelektrische Umwandlungseinheit (PV) die die erste Elektrode (110) kontaktierende erste photoelektrische Umwandlungsschicht (PV1), die zwischen der ersten photoelektrischen Umwandlungsschicht (PV1) und der zweiten Elektrode (140) angeordnete zweite photoelektrische Umwandlungsschicht (PV2) und eine zwischen der zweiten photoelektrischen Umwandlungsschicht (PV2) und der zweiten Elektrode (140) angeordnete dritte photoelektrische Umwandlungsschicht (PV3) umfasst,
wobei die p-Typ Halbleiterschichten (PV2-p, PV3-p) der zweiten photoelektrischen Umwandlungsschicht (PV2) und der dritten photoelektrischen Umwandlungsschicht (PV3) mikrokristallines Silizium (mc-Si) und amorphes Siliziumoxid (a-SiOx) enthalten.

15. Dünnschichtsolarzelle nach Anspruch 14, wobei das amorphe Siliziumoxid (a-SiOx) in den p-Typ Halbleiterschichten (PV2-p, PV3-p), die mikrokristallines Silizium (mc-Si) und amorphes Siliziumoxid (a-SiOx) enthalten, 2 at% bis 10 at% Sauerstoff enthalten, und das mikrokristallines Silizium (mc-Si) 1 at% oder weniger Sauerstoff enthält oder keinen Sauerstoff enthält.

## Revendications

1. Cellule solaire en couche mince comprenant :
un substrat (100) ;
une première électrode (110) positionnée sur une surface du substrat ; et
une unité de conversion photoélectrique (PV) comprenant une première couche de conversion photoélectrique (PV1) en contact avec la première électrode (110) et une deuxième couche de conversion photoélectrique (PV2) positionnée entre la première couche de conversion photoélectrique (PV1) et une deuxième électrode (140), chaque couche de conversion photoélectrique comprenant une couche de semi-conducteur de type p (PV1-p, PV2-p) dopée avec des impuretés d'un premier type conducteur, une couche de semi-conducteur de type i (PV1-i, PV2-i), et une couche de semi-conducteur de type n (PV1-n, PV2-n) dopée avec des impuretés d'un deuxième type conducteur opposé au premier type conducteur,
**caractérisée en ce que**
la couche de semi-conducteur de type n (PV1-n) de la première couche de conversion photoélectrique (PV-1) contient du silicium amorphe (a-Si),
la couche de semi-conducteur de type p (PV2-p) de la deuxième couche de conversion photoélectrique (PV2) contient du silicium microcristallin (mc-Si) et de l'oxyde de silicium amorphe (a-SiOx), et
la couche de semi-conducteur de type i (PV2-i) et la couche de semi-conducteur de type n (PV2-n) de la deuxième couche de conversion photoélectrique (PV2) contiennent du silicium microcristallin (mc-Si).

2. Cellule solaire en couche mince selon la revendication 1, dans laquelle l'oxyde de silicium amorphe (a-SiOx) contenu dans la couche de semi-conducteur de type p (PV2-p) de la deuxième couche de conversion photoélectrique (PV2) contient 2 % at (% atom) à 10 % at d'oxygène,
dans laquelle le silicium microcristallin (mc-Si) contenu dans la couche de semi-conducteur de type p (PV2-p) de la deuxième couche de conversion photoélectrique (PV2) contient 1 % at ou moins d'oxygène ou ne contient pas d'oxygène.

3. Cellule solaire en couche mince selon la revendication 1, dans laquelle la couche de semi-conducteur de type p (PV2-p) de la deuxième couche de conversion photoélectrique (PV2) est directement en contact avec la couche de semi-conducteur de type n (PV1-n) de la première couche de conversion photoélectrique (PV1).

4. Cellule solaire en couche mince selon la revendication 1, dans laquelle une épaisseur de la couche de semi-conducteur de type p (PV2-p) de la deuxième couche de conversion photoélectrique (PV2) est supérieure à une épaisseur de la couche de semi-conducteur de type n (PV1-n) de la première couche de conversion photoélectrique (PV1).

5. Cellule solaire en couche mince selon la revendication 4, dans laquelle l'épaisseur de la couche de semi-conducteur de type p (PV2-p) de la deuxième couche de conversion photoélectrique (PV2) est de 50 nm à 100 nm.

6. Cellule solaire en couche mince selon la revendication 1, dans laquelle la couche de semi-conducteur de type p (PV2-p) de la deuxième couche de conversion photoélectrique (PV2) a une cristallinité de 5 % à 25 %.

7. Cellule solaire en couche mince selon la revendication 1, dans laquelle la couche de semi-conducteur de type p (PV2-p) de la deuxième couche de conversion photoélectrique (PV2) présente une bande interdite de 1,8 à 2,1.

8. Cellule solaire en couche mince seion la revendication 1, dans laquelle la couche de semi-conducteur de type p (PV2-p) de la deuxième couche de conversion photoélectrique (PV2) a un indice de réfraction de 1,8 à 2,6.

9. Cellule solaire en couche mince selon la revendication 1, dans laquelle la couche de semi-conducteur de type p (PV2-p) de la deuxième couche de conversion photoélectrique (PV2) comprend une première couche (PV2-P1) adjacente à la première couche de conversion photoélectrique (PV1) et une deuxième couche (PV2-P2) adjacente à la couche de semi-conducteur de type i (PV2-i) de la deuxième couche de conversion photoélectrique (PV2),
dans laquelle la première couche contient du silicium microcristallin (mc-Si) et du silicium amorphe (a-Si), et
dans laquelle la deuxième couche contient du silicium microcristallin (mc-Si) et de l'oxyde de silicium amorphe (a-Si:Ox).

10. Cellule solaire en couche mince selon la revendication 9, dans laquelle la première couche (PV2-P1) contient 2 % at ou moins d'oxygène ou ne contient pas d'oxygène,
dans laquelle la deuxième couche (PV2-P2) contient 2 % at à 10 % at d'oxygène.

11. Cellule solaire en couche mince selon la revendication 9, dans laquelle une épaisseur de la première couche (PV2-P1) est inférieure à une épaisseur de la deuxième couche (PV2-P2).

12. Cellule solaire en couche mince selon la revendication 9, dans laquelle une épaisseur de la première couche (PV2-P1) est inférieure ou égale à environ 5 nm.

13. Cellule solaire en couche mince selon la revendication 1, dans laquelle chacune de la couche de semi-conducteur de type p (PV1-p), de la couche de semi-conducteur de type i (PV1-i) et de la couche de semi-conducteur de type n (PV1-n) incluses dans la première couche de conversion photoélectrique (PV1) contient du silicium amorphe (a-Si),
dans laquelle chacune de la couche de semi-conducteur de type p (PV2-p), de la couche de semi-conducteur de type i (PV2-i) et de la couche de semi-conducteur de type n (PV2-n) incluses dans la deuxième couche de conversion photoélectrique (PV2) contient du silicium microcristallin (mc-Si).

14. Cellule solaire en couche mince selon la revendication 1, dans laquelle l'unité de conversion photoélectrique (PV) comprend la première couche de conversion photoélectrique (PV1) en contact avec la première électrode (110), la deuxième couche de conversion photoélectrique (PV2) positionnée entre la première couche de conversion photoélectrique (PV1) et la deuxième électrode (140), et une troisième couche de conversion photoélectrique (PV3) positionnée entre la deuxième couche de conversion photoélectrique (PV2) et la deuxième électrode (140),
dans laquelle les couches de semi-conducteur de type p (PV2-p, PV3-p) de la deuxième couche de conversion photoélectrique (PV2) et la troisième couche de conversion photoélectrique (PV3) contiennent du silicium microcristallin (mc-Si) et de l'oxyde de silicium amorphe (a-SiOx).

15. Cellule solaire en couche mince selon la revendication 14, dans laquelle l'oxyde de silicium amorphe (a-SiOx) dans les couches de semi-conducteur de type p (PV2-p, PV3-p) contenant du silicium microcristallin (mc-Si) et de l'oxyde de silicium amorphe (a-SiOx) contient 2 % at à 10 % at d'oxygène, et le silicium microcristallin (mc-Si) contient 1 % at ou moins d'oxygène ou ne contient pas d'oxygène.
